# EUROPEAN PATENT APPLICATION

(11) **EP 3 923 467 A1**
(43) Date of publication of application: **15.12.2021**
(21) Application number: 21178649.6
(22) Date of filing: 09.06.2021
(51) Int. Cl.: H02S 20/32, H02S 40/22, H01L 31/054, H02S 20/22

(54) **DOUBLE-SIDED PHOTOVOLTAIC SOLAR PANEL**

(30) Priority: 09.06.2020 IT 202000013816; 07.06.2021 IT 202100014801
(71) Applicant: Luxmundi, 87060 Caloveto (IT)
(72) Inventor: Acri, Carmela, 87060 Caloveto (IT); Acri, Domenico, 87060 Caloveto (IT)
(74) Representative: Perrotta, Aldo

(57) **Abstract**

A double-sided photovoltaic solar panel (1), consisting of two surfaces for capturing solar energy, of which a front surface arranged on the surface of said solar panel facing the sun, and rear surface arranged on the surface facing away from the surface of said solar panel facing toward the sun, comprising a monoaxial solar tracking system with a rotation axis 5 parallel to the North/South direction in which said panel is formed by two collecting components (2,3) with a parallel side to the rotation axis separated by an opening (4) with two sides parallel to the rotation axis, said opening being symmetrical with respect to the rotation axis, further comprising two inclined reflective surfaces (6,7) arranged in the opening below the plane of the panel in such a way that they are close to it, each reflective surface having a reflection angle in order to reflect the solar radiation onto the rear surface (2B, 3B) of both double-sided photovoltaic panels in a symmetrical manner, characterized by the fact that the rotation axis (5) of the panels has a rhomboidal section and that the reflective surfaces (6, 7) are arranged on two sides of the rhomboidal section of the rotation axis.

## Description

### Technical field of the invention

The present invention concerns a double-sided photovoltaic solar panel with reflective surfaces to increase its yield. The panels that conform with the present invention lend themselves to the realization of fields of panels, due to the absence of external bodies; all this produces an increase in the section resistant to wind and avoids the necessity of constructing support structures that are expensive and not very compact.

### State of the Art

To increase the power supplied by photovoltaic solar panels, produced by the conversion of solar power into electricity, the photovoltaic solar panels have been fitted with reflective surfaces that reflect the power that is radiated by the sun onto additional capturing collecting surfaces, situated on the rear of the panels. Patent WO2020034273A1 describes a double-sided photovoltaic solar panel equipped with reflective surfaces.

The disadvantage of this solution is represented by the fact that the external reflective surfaces are greatly stressed by the force of the wind, with the consequence that resistant, and therefore very expensive, reflective surfaces must be used, and their cost exceeds that of modern double-sided photovoltaic panels by so much that this system has been unsuccessful.

The present invention has been created in order to overcome this and other disadvantages.

### Summary of the invention

The principal aim of the present invention is to create a double-sided photovoltaic solar panel that is capable of being struck by solar radiation on both the anterior and posterior surfaces, increasing its energy power through reflective surfaces which, due to their position, keep the system very compact and maintain a low wind resistance; said aim is achieved through a double-sided photovoltaic solar panel consisting of two surfaces for capturing solar energy, of which an anterior surface is arranged on the surface of said solar panel facing the sun and a rear surface arranged on the side facing in the opposite direction, comprising a mono-axial solar tracking system with a rotation axis parallel to the direction North/South, characterized by the fact that the panel consists of two collection components, separated by a central opening, with one side parallel to the rotation axis and with one side parallel to the rotation axis, also comprising two inclined reflective surfaces, set in the opening below the plane of the photovoltaic panel, with each reflecting surface having an angle of reflection so as to reflect the solar radiation onto the rear surface of each of the flat, double-sided photovoltaic panels.

The inclined reflective surfaces are arranged on the rotation axis having a North/South direction and with a rhomboidal section. Said inclined reflective surfaces rest on two sides of the rhomboid section of the rotation axis. This solution guarantees a perfect support to the inclined reflective surfaces, which will assume the angle of inclination of the two sides of the rhomboidal section. Furthermore, said solution guarantees a smaller section resistant to the wind, a better aerodynamic penetration of the tracker device, a greater compactness and reduced structural costs to counteract the forces caused by the wind.

Another characteristic is given by the fact that the inclined reflective surfaces set in the opening below the plane of the panel are flat surfaces.

Another characteristic is given by the fact that the inclined reflective surfaces set in the opening below the panel plane are concave surfaces.

Another characteristic is given by the fact that the inclined reflective surfaces set in the opening below the plane of the panel are convex surfaces.

Other characteristics and advantages will appear clear from the Figures 1-20, which are given for non-limiting explanatory purposes.

### A brief description of the Figures

Figure 1 represents a double-sided photovoltaic solar panel with flat reflective surfaces conforming with the present invention in a generic position in the morning;
Figure 2 represents a double-sided photovoltaic solar panel with flat reflective surfaces conforming with the present invention with the sun's rays at their zenith;
Figure 3 represents a double-sided photovoltaic solar panel with flat reflective surfaces conforming with the present invention in a generic position in the afternoon;
Figure 4 represents a double-sided photovoltaic solar panel with concave reflective surfaces conforming with the present invention in a generic position in the morning;
Figure 5 represents a double-sided photovoltaic solar panel with concave reflective surfaces conforming with the present invention with the sun's rays at their zenith;
Figure 6 represents a double-sided photovoltaic solar panel with convex reflective surfaces conforming with the present invention in a generic position in the afternoon;
Figure 7 represents a double-sided photovoltaic solar panel with convex reflective surfaces conforming with the present invention in a generic position in the morning;
Figure 8 represents a double-sided photovoltaic solar panel with convex reflective surfaces conforming with the present invention with the sun's rays at their zenith;
Figure 9 represents a double-sided photovoltaic solar panel with convex reflective surfaces conforming with the present invention in a generic position in the afternoon;
Figure 10 represents a row of double-sided photovoltaic solar panels 1 with flat reflective surfaces, concave or convex, conforming with the present invention.

### A detailed description of embodiments of the invention

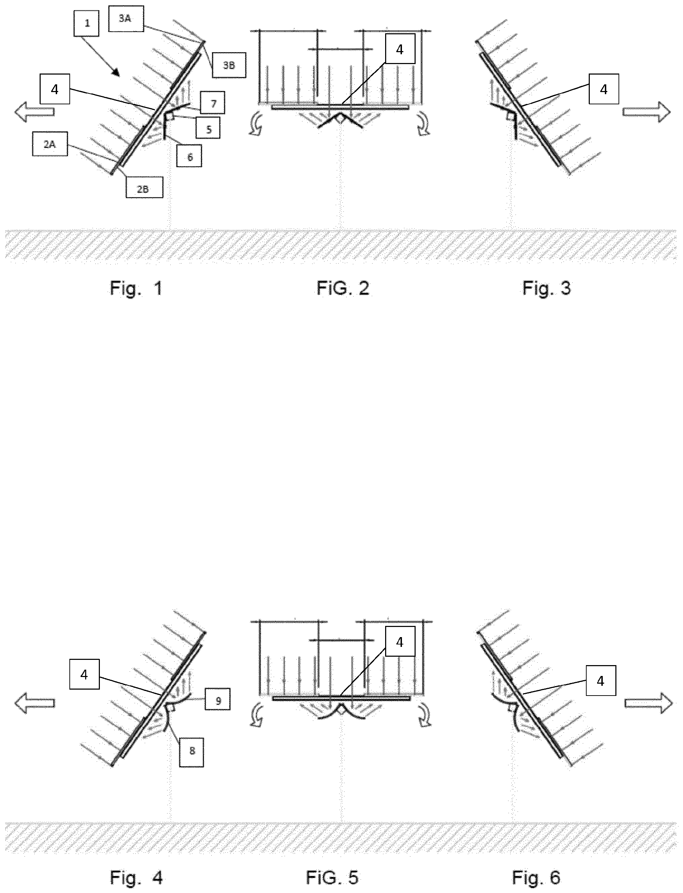

With reference to Figure 1, a double-sided photovoltaic solar panel 1 is shown, having two capturing collecting surfaces, the front surface facing the sun and the rear surface facing in the opposite direction.

The double-sided photovoltaic solar panel 1 has a single-axis rotating solar tracking system rotating on axis 5, said rotation axis having a North/South direction. The double-sided photovoltaic solar panel 1 consists of two capturing collecting components 2 and 3 with one side parallel to the rotation axis, separated by a central opening 4, also with one side parallel to the rotation axis, further comprising two inclined reflective surfaces 6 and 7, set in the opening below the plane of the panel, two sides of the opening are parallel with respect to the axis of rotation, the opening is symmetrical with respect to the axis of rotation, each reflective surface having an angle of reflection to reflect the solar radiation on the posterior surfaces 2B and 3B of each of the capturing collection components 2 and 3.

The inclined reflective surfaces 6 and 7 are arranged on the rotation axis 5 having a North/South direction and having a rhomboidal section. Said inclined reflective surfaces 6 and 7 rest on two sides of the rhomboidal section of the rotation axis 5. This solution guarantees a perfect support for the inclined reflective surfaces 6 and 7, which will assume the inclination angle of the rhomboidal section. Furthermore, this solution guarantees greater compactness to the solar panel, avoiding additional costs to counteract the forces caused by the wind.

Figure 1 represents the double-sided photovoltaic solar panel 1 with flat reflective surfaces in a generic position in the morning.

Figure 2 represents the double-sided photovoltaic solar panel 1 with flat reflective surfaces when it is in its position with the sun's rays at their zenith.

Figure 3 represents the double-sided photovoltaic solar panel 1 with flat reflective surfaces in a generic position in the afternoon.

With reference to Figure 4, a double-sided photovoltaic solar panel is shown, formed of two collecting components 2 and 3 with one side parallel to the rotation axis, separated by an opening 4 also with one side parallel to the rotation axis, further comprising two concave reflective surfaces 8 and 9 set in the opening below the plane of the panel, each reflective surface having a reflection angle in order to reflect the solar radiation onto the rear surface 2B and 3B of each of the capturing collection components 2 and 3.

Figure 4 represents the double-sided photovoltaic solar panel 1 with concave reflective surfaces in a generic position in the morning.

Figure 5 represents the double-sided photovoltaic solar panel 1 with concave reflective surfaces when it is in its position with the sun's rays at its zenith.

Figure 6 represents the double-sided photovoltaic solar panel 1 with concave reflective surfaces in a generic position in the afternoon.

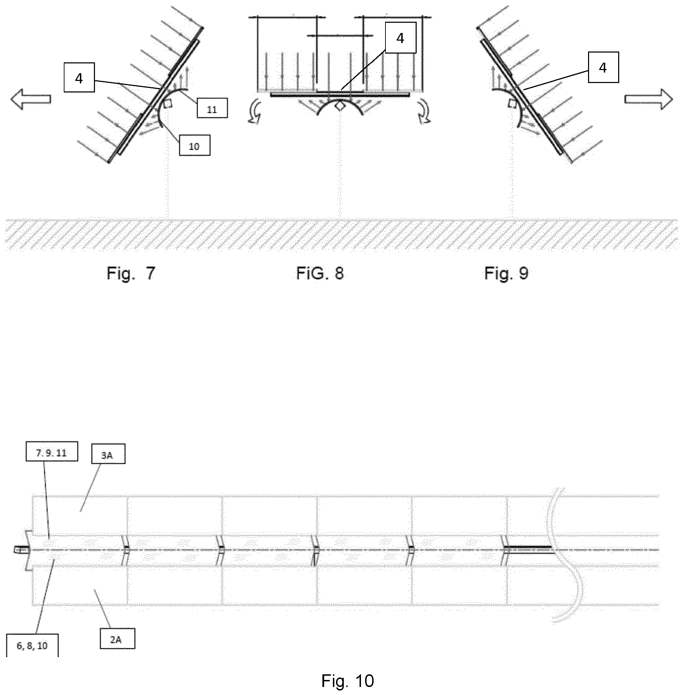

With reference to Figure 7, a double-sided photovoltaic solar panel 1 composed of two capturing collecting components 2 and 3 is shown, with one side parallel to the rotation axis, separated by an opening 4 also having one side parallel to the rotation axis, further comprising two convex reflective surfaces, 10 and 11, set in the opening below the plane of the panel, each reflective surface having a reflection angle in order to reflect the solar radiation on the rear surface 2B and 3B of each of the capturing collecting components 2 and 3.

Figure 7 represents the double-sided photovoltaic solar panel with convex reflective surfaces in a generic position in the morning.

Figure 8 represents the double-sided photovoltaic solar panel 1 with convex reflective surfaces when it is in its position with the sun's rays at its zenith.

Figure 9 represents the double-sided photovoltaic solar panel 1 with convex reflective surfaces in a generic position in the afternoon.

Figure 10 represents a row of double-sided photovoltaic solar panels 1 with flat, concave, or convex reflective surfaces, in the opening between the two capturing collecting components 2 and 3.

The discovery, it is well understood, is not limited to the forms of embodiment described but may be modified and perfected by those skilled in the art without, however, exceeding the limits of patent.

The present invention offers numerous advantages and to overcome difficulties that could not be overcome with the systems currently on the market.

## Claims

1. A double-sided photovoltaic solar panel (1), consisting of two surfaces for capturing solar energy, of which a front surface arranged on the surface of said solar panel facing the sun, and rear surface arranged on the surface facing away from the surface of said solar panel facing toward the sun, comprising a mono-axial solar tracking system with a rotation axis 5 parallel to the North/South direction in which said panel is formed by two collecting components (2,3) with a parallel side to the rotation axis separated by an opening (4) with two sides parallel to the rotation axis, said opening being symmetrical with respect to the rotation axis, further comprising two inclined reflective surfaces (6,7) arranged in the opening below the plane of the panel in such a way that they are close to it, each reflective surface having a reflection angle in order to reflect the solar radiation onto the rear surface (2B, 3B) of both double-sided photovoltaic panels in a symmetrical manner, **characterized by** the fact that the rotation axis (5) of the panels has a rhomboidal section and that the reflective surfaces (6, 7) are arranged on two sides of the rhomboidal section of the rotation axis.

2. A double-sided photovoltaic solar panel according to Claim 1, **characterized by** the fact that the inclined reflective surfaces arranged in the opening below the plane of the panel are flat surfaces.

3. A double-sided photovoltaic solar panel according to Claim 1 or 2, **characterized by** the fact that the inclined reflective surfaces arranged in the opening below the plane of the panel are concave surfaces.

4. A double-sided photovoltaic solar panel according to Claim 1 or 2, **characterized by** the fact that the inclined reflective surfaces arranged in the opening below the plane of the panel are convex surfaces.
